# EUROPEAN PATENT APPLICATION

(11) **EP 4 590 091 A1**
(43) Date of publication of application: **23.07.2025**
(21) Application number: 25152490.6
(22) Date of filing: 17.01.2025
(51) Int. Cl.: H10F 39/00

(54) **IMAGE SENSOR**

(30) Priority: 19.01.2024 KR 20240008938; 01.07.2024 KR 20240086441
(71) Applicant: LX Semicon Co., Ltd., Daejeon 34027 (KR)
(72) Inventor: KIM, Jongman, 34027 Daejeon (KR)
(74) Representative: Ter Meer Steinmeister & Partner

(57) **Abstract**

An image sensor according to an embodiment of the present disclosure includes a first substrate including a logic area, a pad area, and a pixel area including an active array area and a dummy array area disposed around the active array area, the active array area and a dummy array area having a plurality of photoelectric conversion layers, a deep trench disposed in the first substrate in the dummy array area, a plurality of shallow trenches disposed in the first substrate in the logic area, a heat dissipation pad disposed in the pad area, and a metal pattern filled in the deep trench and disposed on the first substrate in the dummy array area and the logic area.

## Description

This application claims the priority benefit of the Korean Patent Applications No. 10-2024-0008938 filed on January 19, 2024 and No. 10-2024-0086441 filed on July 01, 2024.

### BACKGROUND

### Technical Field

The present disclosure relates to an image sensor.

### Description of the Related art

An image sensor is an element that converts an optical image into an electrical signal. The image sensor can include Charge Coupled Device CCD image sensor or Complementary Metal-Oxide Semiconductor CMOS image sensor.

In recent years, with the development of the computer industry and the telecommunication industry, the demand for stacked image sensors with improved performance has increased in various fields such as digital cameras, camcorders, Personal Communication Systems PCS, gaming devices, security cameras, medical micro cameras, and robots.

The image sensor can include a pixel area and a logic area. A plurality of photodiodes, pixel transistors, a plurality of color filters, and a plurality of micro-lenses can be formed in the pixel area. A logic circuit and an input/output circuit can be formed in the logic area. Heat generated in the logic area can move to the pixel area, causing defects such as dark current, white spot, or dark shading, and can also increase resistance of wiring.

### SUMMARY

The present disclosure has been made in view of the above problems, and it is an aspect of the present disclosure to provide an image sensor capable of blocking heat generated in a logit area from moving to a pixel area.

It is another aspect of the present disclosure to provide an image sensor capable of effectively dissipating heat generated in the logic area.

An image sensor according to an embodiment of the present disclosure includes a first substrate including a logic area, a pad area, and a pixel area including an active array area and a dummy array area disposed around the active array area, the active array area and a dummy array area having a plurality of photoelectric conversion layers, a deep trench disposed in the first substrate in the dummy array area, a plurality of shallow trenches disposed in the first substrate in the logic area, a heat dissipation pad disposed in the pad area, and a metal pattern filled in the deep trench and disposed on the first substrate in the dummy array area and the logic area.

An image sensor according to other embodiment of the present disclosure includes a substrate including a pixel area having a plurality of photoelectric conversion layers, a logic area, and a pad area, a first metal pattern disposed on the substrate in the logic area, a second metal pattern filled in a deep trench formed by penetrating the substrate in the pixel area, and a heat dissipation pad disposed in the pad area to dissipate heat generated by the logic area, the heat dissipation pad being electrically connected to the first metal pattern and the second metal pattern.

It is to be understood that both the foregoing general description and the following detailed description are exemplary and explanatory, and are intended to provide further explanation of the inventive concepts as claimed.

In addition to the effects of the present disclosure as mentioned above, additional advantages and features of the present disclosure will be clearly understood by those skilled in the art from the above description of the present disclosure.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a block diagram illustrating an image sensor of an embodiment of the disclosure;
FIG. 2 is an example circuit diagram for describing a unit pixel of an image sensor according to an embodiment of the present disclosure;
FIG. 3 illustrates a conceptual layout of an image sensor of an embodiment of the disclosure;
FIG. 4 is a cross-sectional view according to one embodiment of the present disclosure taken along line I-I' of the image sensor illustrated in FIG. 3; and
FIG. 5 is a cross-sectional view according to another embodiment of the present disclosure taken along line I-I' of the image sensor illustrated in FIG. 3.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION OF THE DISCLOSURE

Hereinafter, example embodiments of the present disclosure will be described in detail with reference to the accompanying drawings. Throughout the present disclosure, identical reference numerals refer to substantially identical elements.

In the following description, when the detailed description of the relevant known function or configuration is determined to unnecessarily obscure the important point of the present disclosure, the detailed description will be omitted. In addition, the names of the elements used in the description below are examples and can differ from the names of the actual product corresponding to the elements.

A shape, a size, a ratio, an angle, and a number disclosed in the drawings for describing exemplary embodiments of the present disclosure are merely an example, and thus, the present disclosure is not limited to the illustrated details.

In a case where "include," "have," "comprise," "contain," "constitute," "make up of," "formed of," and "consist of' described in the present specification are used, another part can be added unless 'only~' is used. The terms of a singular form can include plural forms unless referred to the contrary.

In describing the present disclosure, when one element is referred to as being 'connected to' or 'coupled to' another element, it includes both cases where the one element is directly connected or coupled to another element, or cases where additional element is interposed between the one element and another element.

On the other hand, when the one element is referred to as being 'directly connected to' or 'directly coupled to another element, it means that there are no intervening elements between the one element and another element. The term "And/or" includes each and every combination of one or more of the mentioned items.

In the present disclosure, the terms "frontside" and "backside" are used as relative concepts to easily explain the technical concept of the present disclosure. Therefore, the terms "frontside" and "backside" do not refer to a specific direction, position, or component, and can be interchangeable with each other. For example, 'frontside' can be interpreted as "backside", and "backside" can be interpreted as "frontside". Accordingly, "frontside" can be expressed as "first side' and "backside" can be expressed as "second side", or "backside" can be expressed as "first side" and "front side" can be expressed as "second side". However, the terms "frontside' and "backside" are not used interchangeably within one embodiment.

In construing an element, the element is construed as including an error range although there is no explicit description.

In describing a position relationship, for example, when a position relation between two parts is described as "on", "above", "over", "below", "under", "beside", "beneath", "near", "close to," "adjacent to", "on a side of', "next", one or more other parts can be disposed between the two parts unless 'just' or 'direct' is used.

In describing a time relationship, for example, when the temporal order is described as 'after~', 'subsequent~', 'next~', and 'before~', a case which is not continuous can be included unless 'just' or 'direct' is used.

It will be understood that, although the terms "first", "second" etc. can be used herein to describe various elements, these elements should not be limited by these terms. These terms are only used to distinguish one element from another. Accordingly, a first element mentioned hereinafter could be termed a second element without departing from the scope of the present disclosure.

Features of various exemplary embodiments of the present disclosure can be partially or overall coupled to or combined with each other and can be variously inter-operated or combined with each other and driven technically as those skilled in the art can sufficiently understand. The exemplary embodiments of the present disclosure can be carried out independently from each other, or can be carried out together in co-dependent relationship.

Hereinafter, an image sensor according to an embodiment of the present disclosure will be described with reference to the accompanying drawings.

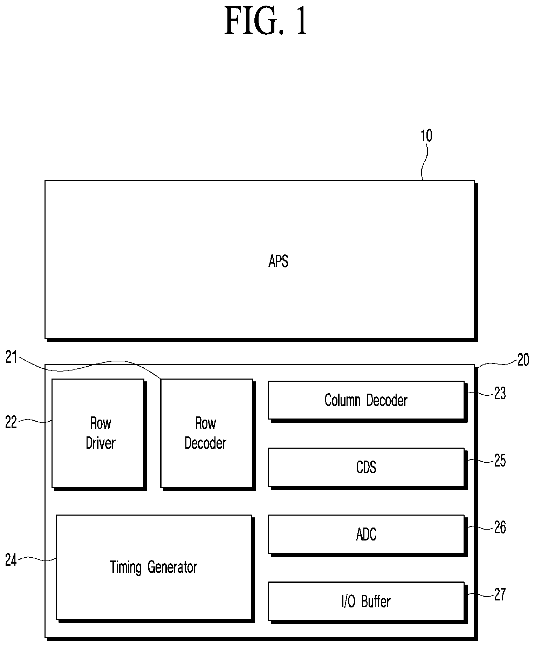

FIG. 1 is a block diagram illustrating an image sensor according to an embodiment of the present disclosure.

As shown FIG. 1, the image sensor according to an embodiment of the present disclosure can include a first block 10 and a second block 20. The first block 10 can be an active pixel sensor array APS. The second block 20 can include a row decoder 21, a row driver 22, a column decoder 23, a timing generator 24, a correlated double sampler CDS 25, an analog-to-digital converter 26 ADC, and an input/output buffer 27.

Although FIG. 1 illustrates that the first block 10 and the second block 20 are arranged in a plan view, the present disclosure is not limited thereto. The first block 10 and the second block 20 can be formed in each chip, and each chip can be stacked to constitute the image sensor. For example, a first chip including the first block 10 and a second chip including the second block 20 can be formed, and the first chip and the second chip can be stacked. In this example, the first chip can be included in an upper substrate, and the second chip can be included in a lower substrate. The upper substrate and the lower substrate can be vertically stacked.

The active pixel sensor array 10 includes a plurality of unit pixels arranged in two dimensions. The active pixel sensor array 10 can convert an optical signal into an electrical signal. The active pixel sensor array 10 can be driven by a plurality of driving signals such as a row selection signal, a reset signal, and an electric charge transfer signal. The driving signals can be provided from the row driver 22. Also, the electrical signal converted by the active pixel sensor array 10 can be provided to the correlated double sampler 25.

The row driver 22 can provide the plurality of driving signals for driving the plurality of unit pixels to the active pixel sensor array 10 according to a result decoded by the row decoder 21. When the unit pixels are arranged in a matrix form, the driving signals can be provided for each row.

The timing generator 24 can provide a timing signal and a control signal to the row decoder 21 and the column decoder 23.

The correlated double sampler 25 can receive, hold, and sample the electrical signal generated by the active pixel sensor array 10. The correlated double sampler 25 can double sample a specific noise level and a signal level by the electrical signal, and output a difference level corresponding to the difference between the noise level and the signal level.

The analog-to-digital converter 26 can convert an analog signal corresponding to the difference level output from the correlated double sampler 25 into a digital signal and output the digital signal.

The input/output buffer 27 can latch the digital signal and can sequentially output the latched signal to an image signal processing unit according to a result decoded in the column decoder 23.

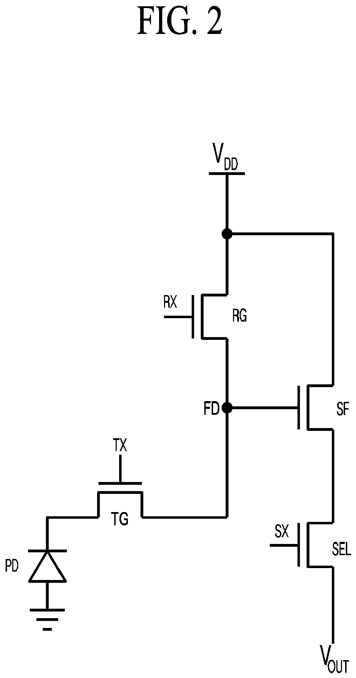

FIG. 2 is an example circuit diagram for describing a unit pixel of an image sensor according to an embodiment of the present disclosure. For reference, in FIG. 2, the unit pixel of the active pixel sensor array 10 shown in FIG. 1 can include four transistors 4T.

Referring to FIG. 2, each unit pixel can include a photoelectric conversion layer PD, a transmission transistor TG, a floating diffusion region FD, a reset transistor RG, a source follower transistor SF, and a selection transistor SEL.

The photoelectric conversion layer PD can generate electric charges in proportion to the amount of light incident from the outside. The photoelectric conversion layer PD can be coupled to the transfer transistor TG that transfers the generated and accumulated electric charges to the floating diffusion region FD. The floating diffusion region FD is a region for converting electric charges into voltage, and has parasitic capacitance, and thus the electric charges can be accumulated and stored.

One end of the transfer transistor TG can be connected to the photoelectric conversion layer PD, and the other end of the transfer transistor TG can be connected to the floating diffusion region FD. The transfer transistor TG can be a transistor driven by a predetermined bias (e.g., the electric charge transfer TX). That is, the transfer transistor TG can transfer the electric charges generated by the photoelectric conversion layer PD to the floating diffusion region FD according to the electric charge transfer signal TX.

The source follower transistor SF can amplify a variation in the electrical potential of the floating diffusion region FD that receives the electric charges from the photoelectric conversion layer PD, and output the amplified electrical potential to the output line VOUT. When the source follower transistor SF is turned on, a predetermined electrical potential, for example, the power supply voltage VDD provided to a drain of the source follower transistor SF, can be transferred to a drain of the selection transistor SEL.

The selection transistor SEL can select the unit pixel to be read in units of rows. The selection transistor SEL can be a transistor driven by a selection line that applies a predetermined bias (e.g., the row selection signal SX).

The reset transistor RG can periodically reset the floating diffusion region FD. The reset transistor RG can be a transistor driven by a reset line that applies a predetermined bias (e.g., the reset signal RX).

When the reset transistor RG is turned on by the reset signal RX, the predetermined electrical potential, for example, the power supply voltage VDD provided to the drain of the reset transistor RG can be transferred to the floating diffusion region FD.

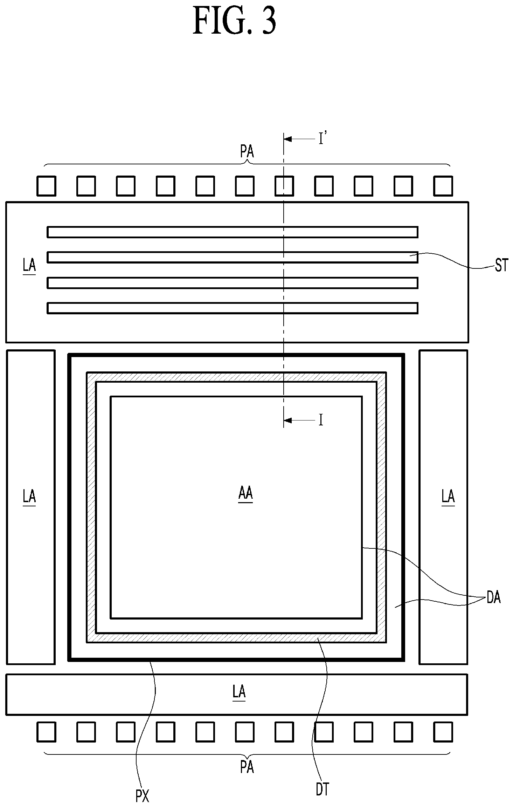

FIG. 3 illustrates a conceptual layout of an image sensor according to an embodiment of the present disclosure.

Referring to FIG. 3, the image sensor according to an embodiment of the present disclosure can include a pixel area PX, a logic area LA, and a pad area PA.

The pixel area PX can be disposed at a center of the image sensor. The pixel area PX can include a plurality of pixels for converting the optical (light) signal into the electrical signal. For example, each pixel can include photodiodes, color filters, micro-lenses, and pixel transistors. The pixel area PX can correspond to the active pixel sensor array 10 shown in FIG. 1. For example, the plurality of unit pixels arranged in two dimensions (e.g. in a matrix form) can be formed in the pixel area PX.

The logic area LA can include various logic circuits such as a correlated double sampler CDS or an image processor that process the electrical signal transferred from the pixel area PX. The logic area LA can be disposed on both sides of the pixel area PX. Alternatively, the logic area LA can be disposed on an upper, lower, left, and right of the pixel area PX.

The pad area PA can include input/output pads and/or through-silicon vias TSVs for electrical connection between the logic area LA and an external circuit. The pad area PA can further include a heat dissipation pad for dissipating heat generated by the image sensor.

The pad area PA can be disposed at an outer area of the logic area LA. That is, the pad area PA can be disposed at the outer area of the logic area LA disposed on one side of the pixel area PX, on upper and lower sides of the pixel area PX, on left and right sides of the pixel area PX, or an upper, lower, left, and right of the pixel area PX. FIG. 3 illustrates that the pad area PA is disposed in the outer area of the logic area LA disposed on the upper and lower sides of the pixel area PX, but is not limited thereto.

The pixel area PX can include an active array area AA and a dummy array area DA. The active array area AA can be disposed at a central portion of the pixel area PX, and the dummy array area DA can be disposed at an edge portion of the pixel area PX to surround the active array area AA.

Active pixels that receive light and generate an active signal can be arranged in the active array area AA. That is, the active array area AA can include a plurality of pixels that convert the optical (light) signal into the electrical signal. For example, each pixel can include photodiodes, color filters, micro-lenses, and pixel transistors.

Dummy pixels can be formed in the dummy array area DA. The dummy pixels can be pixels that do not generate the active signal. The dummy array area DA can generate an optical black signal because light is blocked. That is, color filters and micro-lenses cannot be formed in the dummy pixels.

A deep trench DT can be formed in the dummy array area DA in the pixel area PX. The deep trench DT can block heat (e.g., Joule Heating) generated in the logic area LA from being transferred to the active array area AA in the pixel area PX.

A plurality of shallow trenches ST can be disposed in the logic area LA. The plurality of shallow trenches ST can include bar-shaped trenches. The bar-shaped trenches can be arranged at predetermined intervals in the horizontal direction or vertical direction, or can be arranged in a grid or mesh structure. The plurality of shallow trenches ST can improve an effect of dissipating heat (e.g., Joule Heating) generated in the logic area LA to the outside

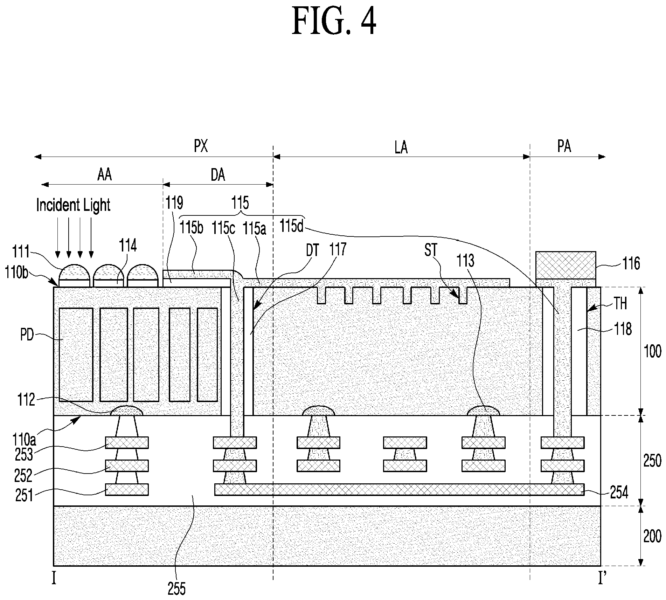

FIG. 4 is a cross-sectional view according to one embodiment of the present disclosure taken along line I-I' of the image sensor illustrated in FIG. 3.

As shown in FIG. 4, the image sensor according to an embodiment of the present disclosure can include a first substrate 100, a second substrate 200 disposed under the first substrate 100, and an intermediate layer 250 disposed between the first substrate 100 and the second substrate 200. The first substrate 100 can be a sensor wafer and the second substrate 200 can be a carrier wafer. The active pixel sensor array APS of the first block 10 described with reference to FIG. 1 can be disposed on the first substrate 100, and some components of the second block 20 described with reference to FIG. 1 can be disposed on the second substrate 200.

The first substrate 100 and the second substrate 200 can be semiconductor substrates. For example, the first substrate 100 and the second substrate 200 can include bulk silicon or a silicon-on-insulator SOI. The first substrate 100 and the second substrate 200 can be silicon substrates or can include other materials, for example, silicon germanium, indium antimonide, lead telluride compound, indium arsenide, indium phosphide, gallium arsenide, or gallium antimonide. The first substrate 100 and the second substrate 200 can be epitaxial layers formed on a base substrate. The first substrate 100 and the second substrate 200 can be electrically connected to each other.

The first substrate 100 can have a first surface 110a and a second surface 110b facing each other. The first surface 110a can be referred to as a front side of the first substrate 100, and the second surface 110b can be referred to as a back side of the first substrate 100. The second surface 110b of the first substrate 100 can be a light receiving surface on which light is incident. That is, the image sensor according to an embodiment of the present disclosure can be a back side illuminated BSI type image sensor.

As shown in FIGS. 3 and 4, the pixel area PX includes the active array area AA and the dummy array area DA.

A plurality of photoelectric conversion layers PD for converting the optical (light) signal into the electrical signal can be disposed two-dimensionally (e.g., in a matrix form) in the first substrate 100 of the pixel area PX including the active array area AA and the dummy array area DA. That is, the plurality of photoelectric conversion layers PD can be disposed two-dimensionally in both the active array area AA and the dummy array area DA of the pixel area PX. For example, each photoelectric conversion layer PD can include at least one of a photo diode, a photo transistor, a photo gate, a pinned photo diode, an organic photo diode, a quantum dot, and a combination thereof, but is not limited thereto.

In the active array area AA of the pixel area PX, a plurality of micro-lenses 111 can be disposed on the second surface 110b of the first substrate 100. The plurality of micro-lenses 111 can be disposed to correspond to the plurality of photoelectric conversion layers PD, respectively. The plurality of micro-lenses 111 can have a convex shape and can have a predetermined radius of curvature. Accordingly, the plurality of micro-lenses 111 can condense light incident on the plurality of photoelectric conversion layers PD. The plurality of micro-lenses 111 can include, for example, a light transmitting resin, but are not limited thereto.

A plurality of color filters 114 can be disposed between the plurality of micro-lenses 111 and the first substrate 100. The plurality of color filters 114 can correspond to the plurality of photoelectric conversion layers PD, and filters of different colors can be disposed on each photoelectric conversion layer PD.

In the pixel area PX, a plurality of first electronic devices 112 can be disposed on the first surface 110a of the first substrate 100. The plurality of first electronic devices 112 can be connected to the plurality of photoelectric conversion layers PD to constitute various transistors for processing the electrical signal. For example, the plurality of first electronic devices 112 can constitute transistors such as the transfer transistor TG, the reset transistor RG, the source follower transistor SF, or the selection transistor SEL described above with reference to FIG. 2.

As shown in FIGS. 3 and 4, the deep trench DT can be formed in the dummy array area DA of the first substrate 100 to surround the active array area AA, and the plurality of shallow trenches ST can be formed in the second surface 110b of the first substrate 100 in the logic area LA. The deep trench DT can penetrate the first substrate 100. The depth of the plurality of shallow trenches ST can be adjusted according to the thickness of the first substrate 100. For example, the depth of the plurality of shallow trenches ST can be less than 1/2 of the thickness of the first substrate 100.

In the pad area PA, a through hole TH penetrating the first substrate 100 can be formed.

A metal pattern 115 can be disposed on the second surface 110b of the first substrate 100 across the dummy array area DA and the logic area LA. The metal pattern 115 can be a single layer or multiple layers consisting of any one of tungsten W, molybdenum Mo, aluminum Al, chromium Cr, gold Au, titanium Ti, nickel Ni, neodymium Nd, and copper Cu, or an alloy thereof.

The metal pattern 115 is filled in the deep trench DT of the dummy array area DA, and the metal pattern 115 is filled in the plurality of shallow trenches ST of the logic area LA. The metal pattern 115 covers the photoelectric conversion layer PD formed in the dummy array area DA. Also, the metal pattern 115 is filled in the through hole TH formed in the pad area PA.

The metal pattern 115 can be divided into a first metal pattern 115a disposed on the second surface 110b of the first substrate 100 of the logic area LA, a second metal pattern 115b disposed on the dummy array area DA of the pixel area PX, a third metal pattern 115c filled in the deep trench DT of the dummy array area DA, and a fourth metal pattern 115d filled in the through hole TH formed in the pad area PA.

Here, the first metal pattern 115a, the second metal pattern 115b, and the third metal pattern 115c can be formed integrally.

An insulating layer 117 can be formed between the third metal pattern 115c filled in the deep trench DT of the dummy array area DA and the first substrate 100, and an insulating layer 118 can be formed between the fourth metal pattern 115d filled in the through hole TH formed in the pad area PA and the first substrate 100. An insulating layer 119 can be formed between the first substrate 100 and the second metal pattern 115b disposed on the dummy array area DA of the pixel area PX. Here, the insulating layers 117, 118, and 119 can include an insulating material such as silicon oxide or silicon nitride.

The insulating layers 117, 118, and 119 can have such a constant thickness that heat transferred to the metal pattern 115 does not affect the first substrate 100 in the deep trench DT and the dummy array area DA. For example, the insulating layer 117 can have a depth of 4 µm to 6 µm and a width of 0.4 µm to 0.7 µm. The insulating layer 118 can have a depth of 4 µm to 6 µm and a width of 0.8 µm to 1.2 µm. The insulating layer 119 can have a thickness of 0.4 µm to 0.7 µm. Accordingly, the first metal pattern 115a of the metal pattern 115 can be in direct contact with the second surface 110b of the first substrate 100 in the logic area LA. On the other hand, the second metal pattern 115b of the metal pattern 115 is not directly contact with the second surface 110b of the first substrate 100 in the dummy array area DA, but is isolated by the insulating layer 119.

In the logic area LA, a plurality of second electronic devices 113 can be disposed on the first surface 110a of the first substrate 100. The plurality of second electronic devices 113 can constitute various transistors configuring various logic circuits, such as the correlated double sampler CDS or the image processor.

In the pad area PA, a heat dissipation pad 116 for dissipating heat generated by the image sensor can be formed on the second surface 110b of the first substrate 100. The heat dissipation pad 116 can be connected to the fourth metal pattern 115d.

A plurality of metal wirings 251, 252, 253, and 254 can be disposed in the intermediate layer 250. The plurality of metal wirings 251, 252, 253, and 254 can be electrically isolated from each other by an interlayer insulating layer 255. The plurality of metal wirings 251, 252, 253, and 254 can include at least one of tungsten W, copper Cu, aluminum Al, gold Au, silver Ag, and alloys thereof, but are not limited thereto. The interlayer insulating layer 255 can include at least one of silicon oxide, silicon nitride, silicon oxynitride, and a low-k material having a dielectric constant lower than that of silicon oxide, but is not limited thereto.

Although FIG. 4 illustrates that the interlayer insulating layer 255 is formed as single layer, the present disclosure is not limited thereto, and the interlayer insulating film 255 can include a plurality of insulating layers. For example, the interlayer insulating layer 255 can include a plurality of insulating layer disposed between the plurality of metal wirings 251, 252, 253, and 254, an insulating layer disposed between the uppermost metal wiring 253 among the metal wirings 251, 252, 253, and 254 and the first substrate 100, and an insulating layer disposed between the lowermost metal wirings 251 and 254 among the metal wirings 251, 252, 253, and 254 and the second substrate 200.

Some of the plurality of metal wirings 251, 252, 253, and 254 can be connected to the first electronic device 112 and the second electronic device 113. At least one metal wiring 254 among the plurality of metal wirings 251, 252, 253, and 254 can be connected to the third metal pattern 115c filled in the deep trench DT. The metal wiring 254 connected to the third metal pattern 115c filled in the deep trench DT can be connected to the heat dissipation pad 116 through the fourth metal pattern 115d disposed in the pad area PA.

Accordingly, heat generated in the logic area LA can be absorbed by the first metal pattern 115a disposed on the second surface 110b of the first substrate 100 in the logic area LA and the third metal pattern 115c filled in the deep trench DT of the dummy array area DA, and heat generated in the intermediate layer 250 in the logic area LA can be absorbed by the metal wiring 254 and dissipated through the heat dissipation pad 116 in the pad area PA. Accordingly, heat generated in the logic area LA can be effectively dissipated.

In particular, since the shallow trenches are formed in the logic area LA, and the first metal pattern 115a is formed thereon, the area of the first metal pattern 115a in contact with the logic area LA is increased. Accordingly, more heat from the logic area LA can be absorbed through the shallow trenches in the logic area LA. Furthermore, since heat from the logic area LA can be absorbed by the third metal pattern 115c filled in the deep trench DT, and heat generated in the intermediate layer 250 in the logic area LA can be absorbed by the metal wiring 254, the heat dissipation effect of the logic area LA can be increased.

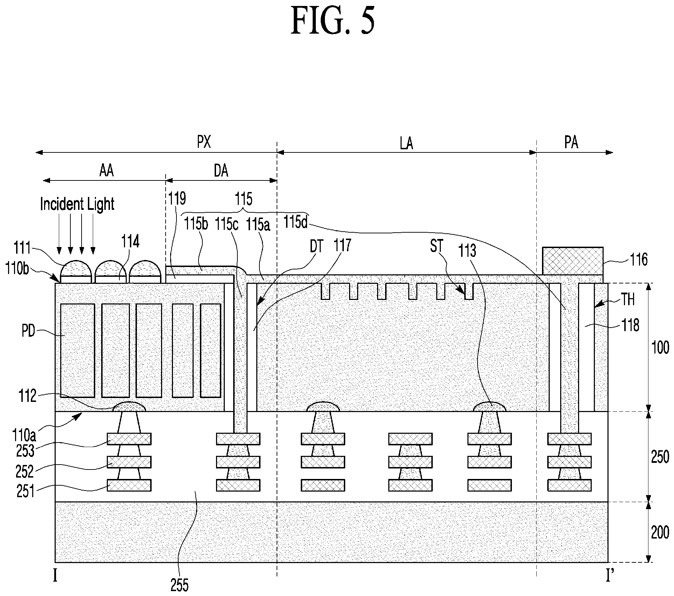

FIG. 5 is a cross-sectional view according to another embodiment of the present disclosure taken along line I-I' of the image sensor illustrated in FIG. 3.

As shown in FIG. 5, the image sensor according to another embodiment of the present disclosure can include a first substrate 100, a second substrate 200 disposed under the first substrate 100, and an intermediate layer 250 disposed between the first substrate 100 and the second substrate 200. The first substrate 100 can be a sensor wafer and the second substrate 200 can be a carrier wafer. The active pixel sensor array APS of the first block 10 described with reference to FIG. 1 can be disposed on the first substrate 100, and some components of the second block 20 described with reference to FIG. 1 can be disposed on the second substrate 200.

The first substrate 100 and the second substrate 200 can be semiconductor substrates. For example, the first substrate 100 and the second substrate 200 can include bulk silicon or a silicon-on-insulator SOI. The first substrate 100 and the second substrate 200 can be silicon substrates or can include other materials, for example, silicon germanium, indium antimonide, lead telluride compound, indium arsenide, indium phosphide, gallium arsenide, or gallium antimonide. The first substrate 100 and the second substrate 200 can be epitaxial layers formed on a base substrate.

The first substrate 100 can have a first surface 110a and a second surface 110b facing each other. The first surface 110a can be referred to as a front side of the first substrate 100, and the second surface 110b can be referred to as a back side of the first substrate 100. The second surface 110b of the first substrate 100 can be a light receiving surface on which light is incident. That is, the image sensor according to an embodiment of the present disclosure can be a back side illuminated BSI type image sensor.

As shown in FIGS. 3 and 5, the pixel area PX includes the active array area AA and the dummy array area DA.

A plurality of photoelectric conversion layers PD for converting the optical (light) signal into the electrical signal can be disposed two-dimensionally (e.g., in a matrix form) in the first substrate 100 of the pixel area PX including the active array area AA and the dummy array area DA. That is, the plurality of photoelectric conversion layers PD can be disposed two-dimensionally in both the active array area AA and the dummy array area DA of the pixel area PX. For example, each photoelectric conversion layer PD can include at least one of a photo diode, a photo transistor, a photo gate, a pinned photo diode, an organic photo diode, a quantum dot, and a combination thereof, but is not limited thereto.

In the active array area AA of the pixel area PX, a plurality of micro-lenses 111 can be disposed on the second surface 110b of the first substrate 100. The plurality of micro-lenses 111 can be disposed to correspond to the plurality of photoelectric conversion layers PD, respectively. The plurality of micro-lenses 111 can have a convex shape and can have a predetermined radius of curvature. Accordingly, the plurality of micro-lenses 111 can condense light incident on the plurality of photoelectric conversion layers PD. The plurality of micro-lenses 111 can include, for example, a light transmitting resin, but are not limited thereto.

A plurality of color filters 114 can be disposed between the plurality of micro-lenses 111 and the first substrate 100. The plurality of color filters 114 can correspond to the plurality of photoelectric conversion layers PD, and filters of different colors can be disposed on each photoelectric conversion layer PD.

In the pixel area PX, a plurality of first electronic devices 112 can be disposed on the first surface 110a of the first substrate 100. The plurality of first electronic devices 112 can be connected to the plurality of photoelectric conversion layers PD to constitute various transistors for processing the electrical signal. For example, the plurality of first electronic devices 112 can constitute transistors such as the transfer transistor TG, the reset transistor RG, the source follower transistor SF, or the selection transistor SEL described above with reference to FIG. 2.

As shown in FIGS. 3 and 5, the deep trench DT can be formed in the dummy array area DA of the first substrate 100 to surround the active array area AA, and the plurality of shallow trenches ST can be formed in the second surface 110b of the first substrate 100 in the logic area LA. The deep trench DT can penetrate the first substrate 100. The depth of the plurality of shallow trenches ST can be adjusted according to the thickness of the first substrate 100. For example, the depth of the plurality of shallow trenches ST can be less than 1/2 of the thickness of the first substrate 100.

In the pad area PA, a through hole TH penetrating the first substrate 100 can be formed.

A metal pattern 115 can be disposed on the second surface 110b of the first substrate 100 across the dummy array area DA, the logic area LA, and the pad area PA. The metal pattern 115 can be a single layer or multiple layers consisting of any one of tungsten W, molybdenum Mo, aluminum Al, chromium Cr, gold Au, titanium Ti, nickel Ni, neodymium Nd, and copper Cu, or an alloy thereof.

The metal pattern 115 is filled in the deep trench DT of the dummy array area DA, and the metal pattern 115 is filled in the plurality of shallow trenches ST of the logic area LA. The metal pattern 115 covers the photoelectric conversion layer PD formed in the dummy array area DA. Also, the metal pattern 115 is filled in the through hole TH formed in the pad area PA.

The metal pattern 115 can be divided into a first metal pattern 115a disposed on the second surface 110b of the first substrate 100 of the logic area LA and extended to the pad area PA, a second metal pattern 115b disposed on the dummy array area DA of the pixel area PX, a third metal pattern 115c filled in the deep trench DT of the dummy array area DA, and a fourth metal pattern 115d filled in the through hole TH formed in the pad area PA.

Here, the first metal pattern 115a, the second metal pattern 115b, the third metal pattern 115c, and the fourth metal pattern 115d can be formed integrally.

An insulating layer 117 can be formed between the third metal pattern 115c filled in the deep trench DT of the dummy array area DA and the first substrate 100, and an insulating layer 118 can be formed between the fourth metal pattern 115d filled in the through hole TH formed in the pad area PA and the first substrate 100. An insulating layer 119 can be formed between the first substrate 100 and the second metal pattern 115b disposed on the dummy array area DA of the pixel area PX. Here, the insulating layers 117, 118, and 119 can include an insulating material such as silicon oxide or silicon nitride.

The insulating layers 117, 118, and 119 can have such a constant thickness that heat transferred to the metal pattern 115 does not affect the first substrate 100 in the deep trench DT and the dummy array area DA. For example, the insulating layer 117 can have a depth of 4 µm to 6 µm and a width of 0.4 µm to 0.7 µm. The insulating layer 118 can have a depth of 4 µm to 6 µm and a width of 0.8 µm to 1.2 µm. The insulating layer 119 can have a thickness of 0.4 µm to 0.7 µm.

Accordingly, the first metal pattern 115a of the metal pattern 115 can be in direct contact with the second surface 110b of the first substrate 100 in the logic area LA. On the other hand, the second metal pattern 115b of the metal pattern 115 is not directly contact with the second surface 110b of the first substrate 100 in the dummy array area DA, but is isolated by the insulating layer 119.

In the logic area LA, a plurality of second electronic devices 113 can be disposed on the first surface 110a of the first substrate 100. The plurality of second electronic devices 113 can constitute various transistors configuring various logic circuits, such as the correlated double sampler CDS or the image processor.

In the pad area PA, a heat dissipation pad 116 for dissipating heat generated by the image sensor can be formed on the second surface 110b of the first substrate 100. The heat dissipation pad 116 can be connected to the fourth metal pattern 115d.

A plurality of metal wirings 251, 252, and 253 can be disposed in the intermediate layer 250. The plurality of metal wirings 251, 252, and 253 can be electrically isolated from each other by an interlayer insulating layer 255. The plurality of metal wirings 251, 252, and 253 can include at least one of tungsten W, copper Cu, aluminum Al, gold Au, silver Ag, and alloys thereof, but are not limited thereto. The interlayer insulating layer 255 can include at least one of silicon oxide, silicon nitride, silicon oxynitride, and a low-k material having a dielectric constant lower than that of silicon oxide, but is not limited thereto.

Although FIG. 5 illustrates that the interlayer insulating layer 255 is formed as single layer, the present disclosure is not limited thereto, and the interlayer insulating film 255 can include a plurality of insulating layers. For example, the interlayer insulating layer 255 can include a plurality of insulating layer disposed between the plurality of metal wirings 251, 252, and 253, an insulating layer disposed between the uppermost metal wiring 253 among the metal wirings 251, 252, and 253 and the first substrate 100, and an insulating layer disposed between the lowermost metal wirings 251 among the metal wirings 251, 252, and 253 and the second substrate 200.

Some of the plurality of metal wirings 251, 252, and 253 can be connected to the first electronic device 112 and the second electronic device 113. At least one metal wiring 253 among the plurality of metal wirings 251, 252, and 253 can be connected to the third metal pattern 115c filled in the deep trench DT.

Accordingly, heat generated in the logic area LA can be absorbed by the first metal pattern 115a disposed on the second surface 110b of the first substrate 100 in the logic area LA and the third metal pattern 115c filled in the deep trench DT of the dummy array area DA, and heat generated in the intermediate layer 250 in the logic area LA can be absorbed by the third metal pattern 115c filled in the deep trench DT of the dummy array area DA through the at least one of the plurality of metal wirings 251, 252, and 253 and dissipated through the heat dissipation pad 116 in the pad area PA. Accordingly, heat generated in the logic area LA can be effectively dissipated.

In particular, since the shallow trenches are formed in the logic area LA, and the first metal pattern 115a is formed thereon, the area of the first metal pattern 115a in contact with the logic area LA is increased. Accordingly, more heat from the logic area LA can be absorbed through the shallow trenches in the logic area LA. Furthermore, since heat from the logic area LA and heat generated by the intermediate layer 250 in the logic area LA can be absorbed by the third metal pattern 115c filled in the deep trench DT, the heat dissipation effect of the logic area LA can be increased.

According to the present disclosure as described above, since the deep trench is formed between the logic area and the pixel area, heat generated in the logic area can be prevented from moving to the pixel area, and the metal pattern formed in the deep trench and the metal pattern formed in the sallow trenches of the logic area can effectively absorb heat from the logic area and dissipate it to the pad area, thereby enhancing the heat dissipation effect.

An image sensor according to various embodiments of the present disclosure can be described as follows.

An image sensor according to an embodiment of the present disclosure includes a first substrate including a logic area, a pad area, and a pixel area including an active array area and a dummy array area disposed around the active array area, the active array area and a dummy array area having a plurality of photoelectric conversion layers, a deep trench disposed in the first substrate in the dummy array area, a plurality of shallow trenches disposed in the first substrate in the logic area, a heat dissipation pad disposed in the pad area, and a metal pattern filled in the deep trench and disposed on the first substrate in the dummy array area and the logic area.

The deep trench can penetrate the first substrate in the dummy array area.

The metal pattern can include a first metal pattern disposed on the first substrate in the logic area to fill the plurality of shallow trenches, a second metal pattern overlapping the plurality of photoelectric conversion layers in the dummy array area, and a third metal pattern filled in the deep trench.

In one or more embodiments, the first metal pattern, the second metal pattern, and the third metal pattern may be formed integrally.

In one or more embodiments, the first metal pattern may directly contact a surface of the first substrate and/or the plurality of shallow trenches formed on the surface of the first substrate.

In one or more embodiments, the second metal pattern may not directly contact the surface of the first substrate in the dummy array area.

The image sensor can further include a through hole disposed in the first substrate in the pad area.

In one or more embodiments, the metal pattern may further comprises a fourth metal pattern filled in the through hole.

In one or more embodiments, the heat dissipation pad may be disposed on the fourth metal pattern.

The image sensor can further include a second substrate disposed below the first substrate and an intermediate layer disposed between the first substrate and the second substrate.

In one or more embodiments, the intermediate layer may comprise a plurality of metal wirings electrically isolated from each other by an interlayer insulating layer.

In one or more embodiments, at least one metal wiring among the plurality of metal wirings may connect the third metal pattern and the fourth metal pattern to each other.

The image sensor can further include an insulating layer disposed between the third metal pattern and the first substrate and between the fourth metal pattern and the first substrate.

The metal pattern of the image sensor according to one embodiment of the present disclosure can be extended to the pad area.

In one or more embodiments, the metal pattern may comprise a first metal pattern disposed on the first substrate in the logic area and the first substrate in the pad area; a second metal pattern overlapping the plurality of photoelectric conversion layers in the dummy array area; and a third metal pattern filled in the deep trench.

In this embodiment, the first metal pattern, the second metal pattern and the third metal pattern can be integrally formed.

In one or more embodiments, the image sensor may further comprise a through hole disposed in the first substrate in the pad area.

In one or more embodiments, the metal pattern may further comprise a fourth metal pattern filled in the through hole.

In one or more embodiments, the heat dissipation pad may be disposed on the fourth metal pattern.

In one or more embodiments, the first metal pattern, the second metal pattern, the third metal pattern, and the fourth metal pattern may be formed integrally.

In one or more embodiments, the image sensor may further comprise a second substrate disposed below the first substrate and an intermediate layer disposed between the first substrate and the second substrate.

In one or more embodiments, the intermediate layer may comprise a plurality of metal wirings electrically isolated from each other by an interlayer insulating layer.

In one or more embodiments, at least one metal wiring among the plurality of metal wirings may connect the third metal pattern.

In another aspect an image sensor is provided comprising: a substrate including a pixel area having a plurality of photoelectric conversion layers, a logic area, and a pad area; a first metal pattern disposed on the substrate in the logic area; a second metal pattern filled in a deep trench formed by penetrating the substrate in the pixel area; and a heat dissipation pad disposed in the pad area to dissipate heat generated by the logic area, the heat dissipation pad being electrically connected to the first metal pattern and the second metal pattern.

In one or more embodiments, the image sensor may further comprise a third metal pattern filled in a through hole by penetrating the substrate in the pad area, the third metal pattern being connected to the heat dissipation pad; and an intermediate layer disposed below the substrate, the intermediate including a metal wiring electrically connecting the first metal pattern and the second metal pattern to the third metal pattern.

In one or more embodiments, the image sensor may further comprise a plurality of shallow trenches formed to have a predetermined depth from a surface of the substrate in the logic area.

In one or more embodiments, the first metal pattern may be extended to the heat dissipation pad to directly contact with the heat dissipation pad.

In one or more embodiments, the first metal pattern may be filled in each of the plurality of shallow trenches.

In the present disclosure, since the deep trench is formed between the logic area and the pixel area, it is possible to prevent heat generated in the logic area from moving to the pixel area.

In addition to, in the present disclosure, by forming a metal pattern within a plurality of shallow trenches formed in the logic area, the metal pattern formed within the shallow trenches can absorb heat generated in the logic area and dissipate it to the pad area, thereby increasing the heat dissipation effect.

In addition to, in the present disclosure, by forming a metal pattern within a deep trench, the metal pattern formed within the deep trench can absorb heat generated in the logic area and dissipate it to the pad area, thereby increasing the heat dissipation effect.

In addition to, in the present disclosure, since heat generated in the logic area can be prevented from moving to the pixel area and heat generated in the logic area can be effectively dissipated, the elements constituting the image sensor can be protected from heat-related damage.

In addition to, in the present disclosure, since elements constituting the image sensor can be protected from heat-related damage, malfunction of elements constituting the image sensor can be prevented.

In addition to, in the present disclosure, since malfunction of elements constituting the image sensor can be prevented, reliability of the image sensor can be improved.

The above-described feature, structure, and effect of the present disclosure are included in at least one embodiment of the present disclosure, but are not limited to only one embodiment. Furthermore, the feature, structure, and effect described in at least one embodiment of the present disclosure can be implemented through combination or modification of other embodiments by those skilled in the art. Therefore, content associated with the combination and modification should be construed as being within the scope of the present disclosure.

It will be apparent to those skilled in the art that various modifications and variations can be made in the present disclosure without departing from the scope of the disclosures. Thus, it is intended that the present disclosure covers the modifications and variations of this disclosure.

The various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. An image sensor comprising:
a first substrate (100) including, a logic area (LA), a pad area (PA), and a pixel area (PX) including an active array area (AA) and a dummy array area (DA) disposed around the active array area (AA), the active array area (AA) and the dummy array area (DA) having a plurality of photoelectric conversion layers (PD);
a deep trench (DT) disposed in the first substrate (100) in the dummy array area (DA);
a plurality of shallow trenches (ST) disposed in the first substrate (100) in the logic area (LA);
a heat dissipation pad (116) disposed in the pad area (PA); and
a metal pattern (115) filled in the deep trench (DT) and disposed on the first substrate (100) in the dummy array area (DA) and the logic area (LA).

2. The image sensor according to claim 1, wherein the deep trench (DT) penetrates the first substrate (100) in the dummy array area (DA).

3. The image sensor according to claim 1 or 2, wherein the metal pattern (115) comprises:
a first metal pattern (115a) disposed on the first substrate (100) in the logic area (LA) to fill the plurality of shallow trenches (ST);
a second metal pattern (115b) overlapping the plurality of photoelectric conversion layers (PD) in the dummy array area (DA); and
a third metal pattern (115c) filled in the deep trench (DT), and

4. The image sensor according to claim 3, wherein the first metal pattern (115a), the second metal pattern (115b), and the third metal pattern (115c) are formed integrally.

5. The image sensor according to claim 3 or 4,
wherein the first metal pattern (115a) directly contacts a surface of the first substrate (100), the plurality of shallow trenches (ST) formed on the surface of the first substrate (100), and/or
wherein the second metal pattern (115b) does not directly contact the surface of the first substrate (100) in the dummy array area (DA).

6. The image sensor according to claim 3, 4 or 5, further comprising a through hole (TH) disposed in the first substrate (100) in the pad area (PA),
wherein the metal pattern (115) further comprises a fourth metal pattern (115d) filled in the through hole (TH), and
wherein the heat dissipation pad (116) is disposed on the fourth metal pattern (115d).

7. The image sensor according to any one of the preceding claims, further comprising:
a second substrate (200) disposed below the first substrate (100); and
an intermediate layer (250) disposed between the first substrate (100) and the second substrate (200).

8. The image sensor according to claim 7, wherein the intermediate layer (250) comprises a plurality of metal wirings (251, 252, 253) electrically isolated from each other by an interlayer insulating layer (255).

9. The image sensor according to claim 8, wherein at least one metal wiring (251, 252, 253) among the plurality of metal wirings (251, 252, 253) connects the third metal pattern (115c) and the fourth metal pattern (115d) to each other.

10. The image sensor according to claim 6, 7, 8 or 9, further comprising an insulating layer (117) disposed between the third metal pattern (115c) and the first substrate (100) and between the fourth metal pattern (115d) and the first substrate (100).

11. The image sensor according to any one of the preceding claims, wherein the metal pattern (115) is extended to the pad area (PA).

12. The image sensor according to claim 11, wherein the metal pattern comprises:
a first metal pattern (115a) disposed on the first substrate (100) in the logic area (LA) and the first substrate (100) in the pad area (PA);
a second metal pattern (115b) overlapping the plurality of photoelectric conversion layers (PD) in the dummy array area (DA); and
a third metal pattern (115c) filled in the deep trench (DT), and
wherein the first metal pattern (115a), the second metal pattern (115b), and the third metal pattern (115c) are formed integrally.

13. The image sensor according to claim 12, further comprising a through hole (TH) disposed in the first substrate (100) in the pad area (PA),
wherein the metal pattern (100) further comprises a fourth metal pattern (115d) filled in the through hole (TH), and
wherein the heat dissipation pad (116) is disposed on the fourth metal pattern (115d).

14. The image sensor according to claim 13, wherein the first metal pattern (115a), the second metal pattern (115b), the third metal pattern (115c), and the fourth metal pattern (115d) are formed integrally.

15. The image sensor according to claim 14, further comprising:
a second substrate (200) disposed below the first substrate (100); and
an intermediate layer (250) disposed between the first substrate (100) and the second substrate (200),
wherein the intermediate layer (250) comprises a plurality of metal wirings (251, 252, 253) electrically isolated from each other by an interlayer insulating layer (255), and
wherein at least one metal wiring (251, 252, 253) among the plurality of metal wirings connects the third metal pattern (115c).
